# EUROPEAN PATENT APPLICATION

(11) **EP 4 369 342 A1**
(43) Date of publication of application: **15.05.2024**
(21) Application number: 22206058.4
(22) Date of filing: 08.11.2022
(51) Int. Cl.: G11C 11/16

(54) **SOT-MRAM DEVICE WITH IN-PLANE MAGNETIC LAYER**

(71) Applicant: Imec VZW, 3001 Leuven (BE)
(72) Inventor: CAI, Kaiming, 3001 Leuven (BE); COUET, Sebastien, 1390 Grez-Doiceau (BE); TALMELLI, Giacomo, 3000 Leuven (BE)
(74) Representative: AWA Sweden AB

(57) **Abstract**

A magnetic tunnel junction, MTJ, device (100) is disclosed, comprising magnetic tunnel-junction, MTJ, element (110) including a magnetic reference layer (112), a magnetic free layer (114), and a non-magnetic barrier layer (113) separating the magnetic reference layer and the magnetic free layer. Further, a spin-orbit torque, SOT, layer structure (120) arranged below the MTJ element and configured to provide a write current switching a magnetization direction of the magnetic free layer through SOT. The SOT layer structure comprises a heavy metal layer (122) and a magnetic layer (124). The magnetic layer is arranged below the heavy metal layer and configured to induce a magnetic field in the magnetic free layer in a direction of the write current through the SOT layer structure, thereby promoting deterministic switching of the magnetization of the magnetic free layer.

## Description

### Technical field

The present disclosure relates to the field of magnetic tunnel-junction, MTJ, devices in which the switching is mediated by spin-orbit torque, SOT. In particular, the present disclosure relates to an MTJ device comprising a SOT layer structure promoting deterministic switching of the magnetization of the magnetic free layer of the MTJ device.

### Background

Magnetoresistive random-access memory (MRAM) technology is a promising candidate for future memory technology. The data storing function of an MRAM device may be provided by magnetic tunnel-junction, MTJ, elements allowing data to be stored and read by controlling and sensing, respectively, the relative orientations of the magnetizations of magnetic free layers and magnetic reference layers of the MTJ elements.

Current MRAM technology typically rely on spin-transfer-torque, STT, as the key switching mechanism of the free layer magnetization. However, alternative switching mechanisms are being researched to increase the switching speed and reduce the power consumption.

One candidate is the so-called spin-orbit-torque, SOT, induced switching, where the magnetization dynamics occurs via a current induced spin-orbit coupling. The SOT is generated by passing a current through a SOT generating layer, in a direction parallel to the MTJ, thereby causing the magnetization of the free layer to switch. Further, an external magnetic field may be required to break the symmetry of the system and to obtain deterministic switching of the magnetization. Such an external magnetic field often has to be applied in the plane of the MTJ, along the direction of the SOT current.

Seeking to solve this issue, common suggestions include realizing a magnetic hard-mask layer arranged above the MTJ. However, the use of such a hard-mask layer increases the complexity of the device processing and makes high density integration more challenging. There is therefore a need for alternative and improved MTJ devices which are more efficient to produce.

### Summary

To at least partly fulfil the above need, the present disclosure seeks to provide an improved MTJ device as defined in the independent claim. Further embodiments of the device are defined in the dependent claims.

According to an aspect of the present disclosure, an MTJ device is provided, comprising an MTJ element including a magnetic reference layer, a magnetic free layer, and a non-magnetic barrier layer separating the magnetic reference layer and the magnetic free layer. Further, the device comprises an SOT layer structure arranged below the MTJ element and configured to provide a write current switching a magnetization direction of the magnetic free layer through SOT. The SOT layer structure comprises a heavy metal layer and a magnetic layer, wherein the magnetic layer is arranged below the heavy metal layer and configured to induce a magnetic field in the magnetic free layer in a direction of the write current through the SOT layer structure, thereby promoting deterministic switching of the magnetization of the magnetic free layer.

The present invention is based on the concept of arranging an in-plane magnetic layer below the heavy metal layer to promote deterministic switching of the free layer. The magnetic layer contributes to the generation of an out-of-plane component of a spin current via spin procession, thereby enabling field-free switching of the MTJ element. The magnetic layer may also contribute to an in-plane (magnetostatic) stray field interaction with the free layer, acting to orient the magnetization direction of the free layer. Further, the magnetic layer may contribute to the Ruderman-Kittel-Kasuya-Yosida (RKKY) exchange coupling. The coupling via stay field or RKKY may replace the external field otherwise provided by a magnetic hard-mask layer above the MTJ element.

The SOT layer structure may therefore be considered as a hybrid SOT layer, in which both the magnetic layer and the heavy metal layer contribute to the spin generation and in which the magnetic layer serves to break the symmetry of the MTJ element.

As a further advantage, the SOT layer structure may be formed below the MTJ element by using the same etching processes as when forming the heavy metal layer. The SOT layer structure is hence compatible with existing integration and manufacturing processes, and does not necessarily require any additional processing blocks as the ones required for forming the above-mentioned magnetic hard-mask layer of the prior art.

In addition, the magnetization of the of the magnetic layer may be defined inherently due to shape anisotropy, thereby eliminating the need for thicker hard masks for additional pinning layers. As a consequence, the integration process of the MTJ device may be simplified.

In some embodiments, the magnetic layer of the SOT layer structure includes a material selected from the group consisting of Fe, Co, Ni, FeCo, FeCoB, NiFe, NdFeB, WCoFeB and TaCoFeB. The material may be deposited on bottom electrodes of the MTJ device and shaped into a layer of desired shape when patterning the heavy metal layer. The magnetic layer may have a thickness in the range of 2-5 nm.

In some embodiments, the magnetic layer may have a length, in a direction of the write current through the heavy metal layer, exceeding a width in a direction orthogonal to the direction of the write current. Such a shape anisotropy allows to favor an easy-axis magnetization direction aligned with the SOT writing current and the provision of field-free switching of the magnetic fee layer. It should however be noted that "aligned with" does not necessarily mean completely parallel with. Preferably, the magnetic layer may have a length-to-width ratio of 3:1 or more.

In some embodiments, the heavy metal layer includes a material selected from the group consisting of W, Ta, and Pt-based alloys such as PtMn, PtCu and PtCr. Further, there may be provided topological insulators of, for instance, BiSe or BiTe forming a spacer layer between the free layer and the magnetic layer of the SOT layer structure. The thickness of the heavy metal layer is beneficially selected to favor spin current transport from the interface to the magnetic layer. The thickness may thus vary depending on the specific material of the heavy metal layer, and may in some examples lie in the range of 2-6 nm on average. As already mentioned, the heavy metal layer may have a lateral shape and length-to-width ratio corresponding to the shape of the magnetic layer.

In some examples, the MTJ element is a top-pinned element. Put differently, the magnetic reference layer is arranged above the magnetic free layer. Alternative configurations are however also possible, with the magnetic free layer arranged above the magnetic reference layer in the stack forming the MTJ element.

In some examples, the magnetic free layer may be formed on the SOT layer structure. The magnetic free layer may, for instance, be formed of a single CoFeB layer or a synthetic-antiferromagnetic hybrid-free layer, and may be deposited directly on the heavy metal layer.

In some embodiments, the MTJ device comprises a plurality of MTJ elements arranged above a common SOT layer structure forming a common SOT track.

A relative orientation of the magnetization directions of the reference layer and the free layer influences an electric resistance of the layer stack forming the MTJ element. The MTJ element may exhibit a relatively low resistance when the magnetization of the reference layer and the free layer are aligned or parallel and a relatively high resistance when the magnetization directions of the reference layer and the free layer are anti-parallel with respect to each other. The tunnel magneto-resistance ratio, TMR, is a measure of the difference in the MTJ electrical resistance between the anti-parallel state and the parallel state.

As used herein, the term "magnetization" of a layer is used to refer to the net magnetization of said layer, i.e., equivalent to the sum of the elementary magnetic moments of the layer, unless explicitly stated otherwise.

By "non-magnetic" is meant a non-ferromagnetic layer or structure presenting no or substantially no net magnetization in absence of an external magnetic field.

In the present disclosure, the wording one layer or structure being arranged or formed above another layer or structure is used to define that said one layer or structure is arranged at a level above said other layer or structure as seen along a bottom-up direction of the layer stack. The term bottom-up direction refers to the stacking direction of the layers of the layer stack, i.e., the direction along which layers or structures are subsequently deposited of formed in the layer stack, or arrange relative to a substrate supporting the layer stack. The terminology bottom-up direction does hence not refer to an absolute orientation of the layers and structures but to a relative ordering or a sequence of the layers and structures forming the MTJ device layer stack, or the sequence in which the layers and structures are formed. Hence, with respect to a substrate supporting the layer stack, a layer or structure arranged above another layer or structure is accordingly arranged farther away from the substrate than said other layer or structure.

Similarly, a layer denoted as an "upper" or "top" layer of a structure refers to its position in the structure, as seen along the bottom-up direction. This applies correspondingly to a structure denoted as an "upper" or "top" structure of, e.g., the layer stack or device.

It should be understood that a corresponding bottom-up frame of reference applies to terms such as "lower", "below", "bottom" and "downward".

As used herein, the terms layer or layer structure, such as the SOT layer structure, the magnetic free layer, the magnetic reference layer and the barrier layer, refer to a structure of one or more layers, e.g., a single layer, or a composite layer of two or more layers or different materials/compositions.

### Brief description of the drawings

Exemplifying embodiments will be described below with reference to the accompanying drawings, in which:
figure 1 schematically illustrates an embodiment of an MTJ device according to the present disclosure;
figure 2a schematically illustrates an embodiment of an MTJ device comprising a plurality of MTJ elements;
figure 2b is a top view of the device in figure 2a; and
figure 3 schematically illustrates an embodiment of an MTJ device according to the present disclosure.

In the drawings, like reference numerals will be used for like elements unless stated otherwise. Unless explicitly stated to the contrary, the drawings show only such elements that are necessary to illustrate the example embodiments, while other elements may be omitted or merely suggested. As illustrated in the figures, the sizes and thicknesses of elements and regions may be exaggerated for illustrative purposes and, thus, are provided to illustrate the general structures of the embodiments.

### Detailed description

Exemplifying embodiments of an MTJ device according to the present disclosure will now be described more fully hereinafter with reference to the accompanying drawing. The drawings show currently preferred embodiments, but the invention may, however, be embodied in many different forms and should not be construed as limited to the embodiments set forth herein; rather, these embodiments are provided for thoroughness and completeness, and fully convey the scope of the present disclosure to the skilled person. The drawings show cross sections and top views of devices, and it is envisaged that the devices may of course extend in directions perpendicular to the plane of the cross sections. The various layers illustrated in the figures may of course also extend laterally/horizontally beyond the illustrated portions, which are for illustrative purposes only.

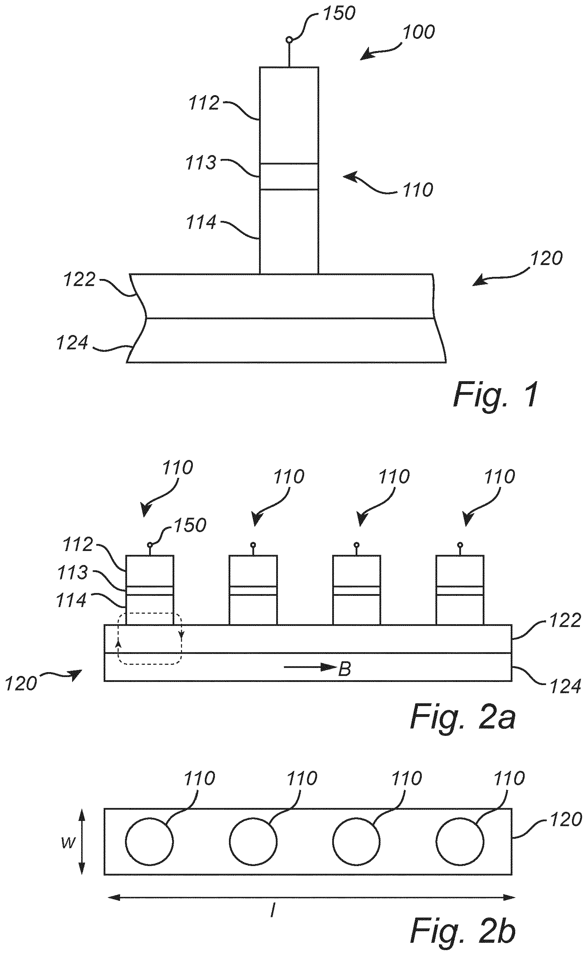

With reference to figure 1, an embodiment of an MTJ device according to the present disclosure will now be described in more detail.

Figure 1 shows schematically an MTJ device 100 after layer deposition and patterning to form one or more MTJ elements, or MTJ pillars, on an SOT layer structure 120. The figure represent a cross section extending parallel to the stacking direction of the layers of the device 100. The stacking direction may also be referred to as a bottom-up direction or vertical direction.

The MTJ device 100 comprises an MTJ element 110 including a magnetic reference layer 112, a magnetic free layer 114 and a barrier layer 113 separating the reference layer 112 and the free layer 114. Further, a spin-orbit torque, SOT, layer structure 120 is arranged below the MTJ element 110 and configured to provide a write current for switching a magnetization direction of the magnetic free layer 114 through SOT. The SOT layer structure 120 comprises a heavy metal layer 122 and a magnetic layer 124 arranged below the heavy metal layer 122. The switching of the magnetization in the magnetic free layer 114 may thus be mediated by spin-orbit torques (SOTs) which may be generated by conduction of the current through the heavy metal layer 122.

However, a magnetic field in the plane of the MTJ and in the direction of the SOT write current is needed to break the symmetry of the system and to obtain a deterministic magnetization switching. To provide field-free switching in the device 100, i.e., without having to supply the needed field in the form of an external magnetic field, the SOT layer structure 120 comprises the magnetic layer 124 for generating an in-plane magnetic stray field in the direction of the write current. This magnetic field may influence the magnetic free layer 114 and induce the field-free switching of the magnetic free layer 114. With this configuration the MTJ element 110 may be written (i.e., caused to assume a parallel or antiparallel magnetization state) by passing a write current through the SOT layer structure 120 via a bottom electrode arrangement (not shown), and read by passing a read current vertically through the layer stack of the MTJ element 110 via a top electrode 150. The device 100 may for example be a memory device used in SOT-MRAM technology.

The MTJ element 110 may be a top-pinned element, in which the reference layer 112 (also referred to as pinned layer) is arranged above the free layer 114. In some examples, a pinning layer (not shown in figure 1) may be provided to pin the direction of magnetization in the magnetic reference layer. The pinning layer may be arranged on top of the magnetic reference layer 112 and may for example be a synthetic antiferromagnetic layer. In general, it is appreciated that the reference layer 112, the free layer 114 and the pinning layer (if included) may be of, or at least include, materials that possess perpendicular magnetic anisotropy, PMA. The pinning layer may in turn include multiple sublayers, for example first and second magnetic sublayers separated by a thin metal layer.

Examples of materials for the reference layer 112 may include Fe, Co, CoFe, CoB, FeB, WCoFeB and CoFeB. Other suitable materials may for example include Ni, NePt, CoGd, CoFeGd, CoFeTb and CoTb. Is is envisaged that the reference layer 112 may have a multilayer structure including combinations of the aforementioned materials.

The barrier layer 113, or tunnel barrier layer, may be arranged or formed on the magnetic free layer 114. The barrier layer 113 may for example include a layer of a dielectric material, for example MgO, AlOx, MgAlOx or MgTiOx and may be adapted to allow electrons to tunnel between the reference layer 113 and the free layer 114.

The SOT layer structure 120 is in figure 1 is formed of the heavy metal layer 122 and the underlying magnetic layer 124. The heavy metal layer 112 may include a layer or an electrically conducting material presenting a relatively large spin-orbit coupling. The heavy metal layer 122 may be non-magnetic, and example materials for the heavy metal layer 122 may include metals such as Ta, W, Pt, Cu, Pd, Ir, IrMn, PtMn, PtCr, WOx, WN, W(O, N), AuPt, Hf, PtHf, FeMn, NiMn or topological insulators such as BiSe or BiTe, such as BiₓSe₁₋ₓ, BiₓSb₁₋ₓ, (Bi, Sb)₂Te₃ or transition metal dichalcogenide (TMD) such as MoS₂, WTe₂. The heavy metal layer 122 may also have a multi-layer structure, e.g. including combinations of any of the above-mentioned materials. The heavy metal layer 122 may be formed with a thickness of e.g. 10 nm or less, preferably 6 nm or less, such as 2-6 nm, and may be formed using conventional deposition techniques such as evaporation or sputtering or MBE (molecular beam epitaxy), or ALD (atomic layer deposition), or MOCVD (metal organic chemical vapor deposition).

The magnetic layer 124 may include a ferromagnetic material, such as one or several of Fe, Co, Ni, FeCo, FeCoB, NiFe, NdFeB and TaCoFeB. The magnetic layer 124 may be formed with a thickness of 10 nm or less, such as 5 nm or less, such as 2-5 nm, and may be formed using conventional deposition techniques as discussed above in connection with the heavy metal layer 122. The magnetization direction of the layer 122 may be determined by the shape of the layer (i.e., shape anisotropy). To provide a magnetization direction aligned with the direction of the write current through the heavy metal layer 122, the magnetic layer 124 may have a length in the direction of the write current that exceeds a width of the magnetic layer in a direction orthogonal to the direction of the write current. Preferably, the length-to-width ratio of the magnetic layer 124 is 3:1 or more. This will be discussed in greater detail in connection with figure 2b.

The shape of the magnetic layer 124 may be determined by the shape of the heavy metal 122, and the two layers may in some examples be defined in a common etching step.

The heavy metal layer 122 and the magnetic layer 124 may together form a hybrid SOT layer 120, in which both the heavy metal layer 122 and the magnetic layer 124 contribute to the spin generation and in which the magnetic layer 124 serves to break the magnetic symmetry of the MTJ element 110 to prevent stochastic switching of the free layer 114. The magnetic layer 124 should thus be configured to generate an in-plane magnetic field having a strength sufficient to obtain the desired field-free switching of the free layer 114 of the MTJ element 110. Herein, "field-free switching" means not that no magnetic field is present, but that such a field is not an external magnetic field. Instead, as described herein, the magnetic field is generated internally within the device, by the addition of the magnetic layer 124 below the heavy metal layer 122 of SOT layer structure 120.

The layer stack forming the MTJ device 100 may be supported by a substrate (not shown). The substrate may comprise a semiconductor substrate. Example of semiconductor substrates include a Si substrate, a Ge substrate, a SiGe substrate, a SiC substrate, an SOI substrate, a GeOI substrate, or a SiGeOI substrate to name a few. The substrate may have been subjected to front-end-of-line (FEOL) processing to define an active device layer comprising active devices, such as transistor devices including, for example, MOSFETs, MISFETs, BJTs, JBTs, FinFETs, and nanowire FETs. The transistors may be used to implement circuitry for reading and writing operations of MTJ devices 100 which are to be formed.

Although not shown in figure 1, one or more levels of a BEOL-interconnect structure may be formed above the substrate, e.g., on the active device layer, on which the layer structure in turn may be formed. An interconnect level may comprise horizontal metal lines and vertical vias. The metal lines may be embedded in a dielectric material, typically comprising silicon oxide or other conventional low-k dielectric material. One or more of the interconnection levels may for example define read and write lines of the MTJ devices. The BEOL portion may be formed using conventional BEOL-processing.

The MTJ device 100 may be formed on a BEOL-interconnect layer of the active device layer. Each one of the layers and layer structures of the MTJ device 100 may be deposited for instance by sputtering or evaporation of other suitable thin-film deposition techniques per se known in the art.

Figure 2a shows an MTJ device 100 which may be similarly configured as the device 100 of figure 1, with the difference that it comprises a plurality of MTJ elements 110 arranged on a common SOT layer structure 120. The effective field for field-free switching, generated in the free layer 114 by the magnetic layer 124, is indicated by the dashed line at the leftmost MTJ element 110, whereas the magnetization direction in the magnetic layer 124 is indicated by the arrow B. As shown in the present figure, the in-plane magnet layer 124 is separated from the MTJ elements 110 by the heavy metal layer 122, which can accommodate multiple MTJ elements 110 and thereby enable voltage-controlled selective read/write operations.

Figure 2b is a top view of the device 100 in figure 2a, showing the MTJ elements 110 aligned in a one-dimensional array along a track formed by the SOT layer structure 120. The SOT layer structure 120 has an elongated shape, with a length I in a direction of the write current through the heavy metal layer 122 exceeding a width w in a direction orthogonal to the direction of the write current, to allow for a shape anisotropy defining the magnetization direction of the magnetic layer 124 along the direction of the write current. By utilizing shape anisotropy the need for additional pinning layers for the magnetic layer 124. Preferably the length I of the layer exceeds the width w by a factor 3 or more.

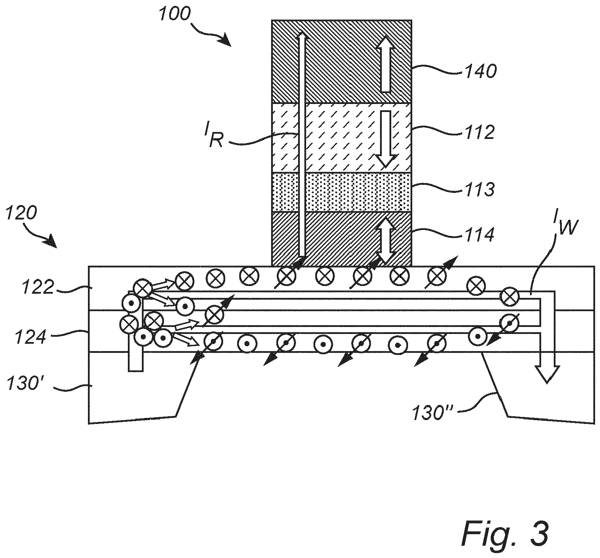

Figure 3 shows an MTJ device 100 which may be similar to the ones discussed above with reference to figures 1 and 2a-b. The magnetic layer 124 may be formed on an electrode layer, comprising a first and a second bottom electrode 130', 130". The electrode layer is configured to provide the write current I_{W} through the SOT layer structure 120 arranged above the electrodes 130', 130", as indicated in the present figure. The write current Iw allows for a spin current to be generated, whereas the in-plane stray field in the free layer 114 contributed to the RKKY coupling and potentially additional spin generation. The spin current flowing through the interface of the heavy metal layer 122 and the magnetic layer 124 of the SOT layer structure 120 results in an out-of-plane component of the spin current via spin procession, which may also contribute to the field-free switching of the MTJ element 110.

Figure 3 further shows a pinning layer 140 for pinning the direction of magnetization in the magnetic reference layer 112. The pinning layer is arranged on top of the magnetic reference layer 112 and may for example be a synthetic antiferromagnetic layer.

As indicated by the arrows in the reference layer 112 and the free layer 114, respectively, the layer structures 112, 114 may each be layers possessing at least to some extend a perpendicular magnetic anisotropy, PMA. The respective magnetization directions of the reference layer 112 and the free layer 114 may be set by applying appropriately oriented magnetic fields during device fabrication, as per se is known in the art.

The fee layer 114 has a net magnetization which may be varied. That is, the direction of the net magnetization / net magnetic moment of the free layer 114 may be varied. Meanwhile, the reference layer 112 has a net magnetization which is fixed or pinned by the pinning layer 140. As indicated by the double arrow in the free layer 114, the magnetization of the free layer 114 may be varied between two states, a "parallel" state (wherein the magnetization of the free layer 114 is oriented parallel to or at least along the magnetization direction of the reference layer 112) and an "anti-parallel" state (wherein the magnetization direction of the free layer 114 is oriented anti-parallel to or at least against the magnetization direction of the reference layer 112. The magnetization directions of the pinning layer 140 and the reference layer 112 may, as indicated by the respective arrows in figure 3, be oriented in opposite directions due to an anti-parallel magnetization coupling between the pinning and reference layer 140, 112. However, it is also possible they are aligned with each other.

The MTJ device 100 shown in figure 3 may be considered a three-terminal resistive memory element that is connected with two access transistors, forming a 2T1R bit-cell. Further, a write circuit may be provided, including driving transistors that are controlled by logic signal in order to produce the SOT generating current. Further, a read circuit may be provided, including sensing amplifiers.

During the write operation, the MTJ element 110 may be switched either from the parallel to the anti-parallel state, or from the anti-parallel to the parallel state by controlling the write circuit to generate the SOT generating current through the SOT layer structure 120. Thus, depending on the direction of the write current I_{W}, the free layer 114 may be switched to a parallel or anti-parallel state in accordance with the coupling to the magnetic layer 124 of the SOT layer structure 120.

A transistor may be arranged to control access to the top electrode of the MTJ element, and thus to control the read current I_{R} flowing through the layer stack of the MTJ element 110. The data stored in the MTJ element 110 may be represented by the magnetization direction of the free layer 114 and detectable by the resistance experienced by the read current I_{R} as it passes through the MTJ element 110. Thus, a read operation of the MTJ device 100 may comprise measuring the resistance across the layer stack of the MTJ element 110, between the top electrode and the bottom electrode 130', 130". A parallel state of the free layer 124 will result in a lower resistance than an anti-parallel state of the free layer 124, the difference being given by the TMR of the MTJ element 110. A logical "1" may be associated with the lower resistance and a logical "0" may be associated with the higher resistance, or vice versa.

In the above, the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A magnetic tunnel junction, MTJ, device (100), comprising:
a magnetic tunnel-junction, MTJ, element (110) including a magnetic reference layer (112), a magnetic free layer (114), and a non-magnetic barrier layer (113) separating the magnetic reference layer and the magnetic free layer; and
a spin-orbit torque, SOT, layer structure (120) arranged below the MTJ element and configured to provide a write current switching a magnetization direction of the magnetic free layer through SOT;
wherein the SOT layer structure comprises a heavy metal layer (122) and a magnetic layer (124); and
wherein the magnetic layer is arranged below the heavy metal layer and configured to induce a magnetic field in the magnetic free layer in a direction of the write current through the SOT layer structure, thereby promoting deterministic switching of the magnetization of the magnetic free layer.

2. The MTJ device according to claim 1, wherein the magnetic layer includes a material selected from the group consisting of Fe, Co, Ni, FeCo, FeCoB, NiFe, NdFeB, WCoFeB, and TaCoFeB.

3. The MTJ device according to claim 1 or 2, wherein the magnetic layer has an average thickness in the range of 2-5 nm.

4. The MTJ device according to any of the preceding claims, wherein the magnetic layer is formed on a bottom electrode (130) of the MTJ device.

5. The MTJ device according to any of the preceding claims, wherein a length (I) of the magnetic layer, in a direction of the write current through the heavy metal layer, exceeds a width (w) of the magnetic layer in a direction orthogonal to the direction of the write current.

6. The MTJ device according to claim 5, wherein a length-to-width ratio of the magnetic layer is 3:1 or more.

7. The MTJ device according to any of the preceding claims, wherein the heavy metal layer includes a material selected from the group consisting of W, Ta, Pt, PtMn, Pt, Cu and PtCr.

8. The MTJ device according to claim 7, wherein the SOT layer structure further includes a topological insulator layer including a material selected from the group consisting of BiₓSe₁₋ₓ, BixSbi-x, and (Bi, Sb)₂Te₃.

9. The MTJ device according to any of the preceding claims, wherein the heavy metal layer has an average thickness in the range of 2-6 nm.

10. The MTJ device according to any of the preceding claims, wherein the heavy metal layer has a shape corresponding to a shape of the magnetic layer.

11. The MTJ device according to any of the preceding claims, wherein the MTJ element is a top-pinned element.

12. The MTJ device according to any of the preceding claims, wherein the magnetic free layer is formed on the SOT layer structure.

13. The MTJ device according to any of the preceding claims, wherein the magnetic free layer is formed of a single CoFeB layer or a synthetic-antiferromagnetic hybrid-free layer.

14. The MTJ device according to any of the preceding claims, comprising a plurality of MTJ elements, and wherein the SOT layer structure is common to the plurality of MTJ elements.
